**Europäisches Patentamt**

**European Patent Office**

**Office européen des brevets**

(19)

(11) Veröffentlichungsnummer : **0 447 928 B1**

(12) **EUROPÄISCHE PATENTSCHRIFT**

(45) Veröffentlichungstag der Patentschrift :
02.08.95 Patentblatt 95/31

(51) Int. Cl.⁶ : **H01M 10/48, G01R 31/36**

(21) Anmeldenummer : **91103775.2**

(22) Anmeldetag : **13.03.91**

(54) **Verfahren und Batterieprüfgerät zum Bestimmen des Zustands einer Bleibatterie.**

(30) Priorität : **13.03.90 DE 4007883**

(43) Veröffentlichungstag der Anmeldung :
**25.09.91 Patentblatt 91/39**

(45) Bekanntmachung des Hinweises auf die
Patenterteilung :
**02.08.95 Patentblatt 95/31**

(84) Benannte Vertragsstaaten :
**AT CH DE ES FR GB IT LI SE**

(56) Entgegenhaltungen :
**DE-A- 3 407 409**
**DE-B- 2 043 660**
**DE-B- 2 610 536**
**DE-B- 2 842 817**
**GB-A- 1 454 358**

(73) Patentinhaber : **Moto Meter AG**
**Daimler Strasse 6**
**D-71229 Leonberg (DE)**

(72) Erfinder : **Nann, Eberhard, Dr.phil.nat.**
**Schmückersweg 2**
**W-4770 Soest-Deiringsen (DE)**
Erfinder : **Junge, Volkmar**
**Hans-Geraly-Strasse 14**
**W-6742 Herxheim (DE)**
Erfinder : **Becker, Raimund**
**Hansjakobweg 12**
**D-7505 Ettlingen (DE)**
Erfinder : **Schroeder, Reiner**
**Rösselsbrünnle Strasse 14**
**W-7512 Rheinstetten 2 (DE)**

(74) Vertreter : **Behrens, Ralf Holger**
**Robert Bosch GmbH**
**Zentralabteilung Patente**
**Postfach 30 02 20**
**D-70442 Stuttgart (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Bestimmen des Zustands einer Bleibatterie, insbesondere einer Starterbatterie, bei dem die Batterie für die Dauer eines begrenzten Zeitintervalls mit einem hohen Entladestrom entladen wird und bei dem die Entladeschlußspannung am Ende dieses Zeitintervalls zur Bestimmung des Zustands der Batterie gemessen wird, sowie ein Batterieprüfgerät zur Durchführung des Verfahrens.

Zur Prüfung des Ladezustands von Batterien ist es bekannt, die Dichte der Säure in einer Bleibatterie bzw. einem Bleiakkumulator zu messen, und die ermittelte Säuredichte ist ein gutes Maß für den aktuellen Ladezustand der Batterie. Nachteilig an diesem Verfahren ist es jedoch, daß die Batteriesäure in vielen Fällen nicht ohne weiteres zugänglich ist, speziell bei den wartungsfreien Batterien, die als Starterbatterien zunehmende Bedeutung gewinnen. Außerdem gibt die Säuredichte keinerlei Hinweis auf alterungsbedingte Leistungsverluste der geprüften Batterie, sofern keine Kurzschlüsse vorliegen.

Der Ladezustand der Batterie läßt sich auch anhand der Klemmenspannung der Batterie feststellen, wobei die gemessene Klemmenspannung jedoch nur dann ein direktes Maß für den Ladezustand der Batterie ist, wenn die Messung zu einem Zeitpunkt erfolgt, zu dem sich nach vorausgegangenen Lade- und/oder Entladevorgängen tatsächlich eine aussagekräftige Ruhespannung eingestellt hat. Dabei ist davon auszugehen, daß diese Ruhespannung bei einer zu einem Kraftfahrzeug gehörigen Starterbatterie, welche bei laufendem Fahrzeugmotor zuvor für eine mehr oder weniger lange Zeit über den Spannungsregler des Kraftfahrzeugs aufgeladen wurde, erst nach etwa zehn Stunden erreicht wird. Wenn also ein Kunde mit seinem Kraftfahrzeug in einer Werkstatt vorfährt, um den Zustand seiner Starterbatterie prüfen zu lassen, dann besteht bisher keine Möglichkeit, den Batteriezustand kurzfristig mit einer einigermaßen befriedigenden Genauigkeit zu bestimmen. Vielmehr kann die Ruhespannung der Batterie erst nach einer Zeit von zehn Stunden einigermaßen korrekt gemessen werden, um anschließend durch Belastung der Batterie mit einem hohen Entladestrom, insbesondere dem sogenannten Kälteprüfstrom, Aussagen über den alterungsbedingten Zustand der Batterie, insbesondere über den Startfähigkeitsverlust derselben, machen zu können.

Aus der DE 34 07 409 A1 ist ein weiteres Prüfverfahren bzw. ein entsprechendes Prüfgerät bekannt, bei dem der Ladezustand eines Akkumulators ermittelt wird. Bei diesem Prüfverfahren wird zunächst der Prüfling hochstrombelastet. Anschließend wird die Leerlaufspannung der Batterie gemessen. Zusätzlich wird der Gleichstrominnenwiderstand des Prüflings erfaßt und durch Verhältnisbildung dieses Wertes mit dem bekannten Gleichstrominnenwiderstand einer neuen, vollgeladenen Batterie gleichen Typs verglichen. Aus diesem Vergleich wird eine Maßzahl für das momentane Startvermögen des Akkumulators gewonnen, die zur Bewertung des Ladezustands des Akkumulators verwendet wird.

Ausgehend vom Stand der Technik liegt der Erfindung die Aufgabe zugrunde, ein verbessertes Verfahren zum Bestimmen des Zustands einer Batterie anzugeben, mit dem es, unabhängig vom Ausgangszustand der Batterie, innerhalb weniger Minuten möglich ist, vergleichsweise genaue Werte bezüglich des Ladezustands und des Verlustes der Startfähigkeit zu machen, sowie ein Batterieprüfgerät zur Durchführung des Verfahrens vorzuschlagen.

Die gestellte Aufgabe wird, was das Verfahren anbelangt, gemäß der Erfindung durch folgende Verfahrensschritte gelöst:

in einem ersten Entladeschritt wird die Batterie für die Dauer einiger Sekunden zum Ausgleich des sogenannten Spannungssackes mit einem hohen ersten Entladestrom entladen;

in einem zweiten Entladeschritt wird die Batterie anschließend für die Dauer einiger Minuten mit einem vorgegebenen, relativ niedrigen, konstanten, zweiten Entladestrom entladen;

nach dem zweiten Entladeschritt werden die Batterietemperatur und die Batteriespannung mit Hilfe von Temperatur- bzw. Spannungsmeßeinrichtungen gemessen;

in Abhängigkeit von der gemessenen Batterietemperatur und der gemessenen Batteriespannung wird anhand von in Speichereinrichtungen gespeicherten Daten einer für den zu prüfenden Batterietyp geltenden Ladezustandskurvenschar der relative Ladezustand der zu prüfenden Batterie, bezogen auf eine voll aufgeladene Batterie dieses Typs, ermittelt;

in einem dritten Entladeschritt wird die Batterie für die Dauer eines Zeitintervalls von einigen Sekunden mit einem genau vorgegebenen hohen, konstanten, dritten Entladestrom entladen;

die bei dem dritten Entladeschritt erreichte Entladeschlußspannung wird mit Hilfe der Spannungsmeßeinrichtungen gemessen;

mit Hilfe von Vergleichseinrichtungen wird die Spannungsdifferenz zwischen dem Wert der gemessenen Entladeschlußspannung und einem Spannungswert ermittelt, welcher gemäß den in den Speichereinrichtungen abgelegten Daten einer Ladezustandskurvenschar für eine neuwertige Batterie, ausgehend von dem am Ende des zweiten Entladeschrittes ermittelten Ladezustand, bei der am Ende des zweiten Entladeschrttes ermittelten Temperatur und bei einer Entladung mit dem genau vorgegebenen hohen, konstanten dritten Entladestrom gelten würde; und

aufgrund der ermittelten Spannungsdifferenz wird anhand der in den Speichereinrichtungen gespeicherten Daten einer dem Verlust der Startfähigkeit des zu prüfenden Batterietyps zugeordneten Kurve der dem Ladezustand entsprechende relative Verlust der Startfähigkeit, bezogen auf eine neuwertige Batterie gleichen Ladezustands, ermittelt bzw. die zum Zeitpunkt der Prüfung noch vorhandene relative Startfähigkeit, wobei die erste und die zweite Ladezustandskurvenschar vorgegebene Kurven umfassen, die für den zu prüfenden Batterietyp sowie für den zweiten bzw. dritten Entladestrom gelten und die Batteriespannung und den Ladezustand bei den betreffenden Temperaturen miteinander verknüpfen.

Es ist ein besonderer Vorteil des erfindungsgemäßen Verfahrens, daß durch die den eigentlichen Messungen vorausgehende Entladung mit einem hohen Strom innerhalb weniger Sekunden ein definierter Ausgangszustand geschaffen werden kann, da es nach dieser kurzfristigen Hochstromentladung keine Rolle mehr spielt, ob zuvor eine Aufladung über Lichtmaschine und Regler erfolgt ist oder nicht. Insbesondere wird durch die kurzfristige Hochstromentladung bei den anschließenden Messungen das Auftreten eines sogenannten Spannungssackes, nämlich eines vorübergehenden Abfalls der Batteriespannung, wie er nach einer vorausgegangenen Aufladephase aufgrund von Polarisationseffekten in der Batterie auftritt, wirksam verhindert.

Nach der Vorentladung lassen sich dann durch Entladung mit einem relativ niedrigen Strom, insbesondere in der Größenordnung des auf die Nennkapazität der Batterie bezogenen Entladestroms ($I_{20}$ nach DIN 43 539), stabile Betriebsbedingungen der Batterie erreichen, so daß eine aussagekräftige Batteriespannung bereits nach wenigen Minuten, beispielsweise nach 5 bis 10 Minuten, gemessen und folglich aufgrund der gemessenen Batteriespannung und der gleichzeitig gemessenen Batterietemperatur ein genauer Wert für den Ladezustand der Batterie angegeben werden kann. Für eine Batterie vorgegebenen Typs und vorgegebener Kapazität sind nämlich Ladezustandskurven - je eine Kurve für jede Temperatur - verfügbar, die anhand der gemessenen Temperatur (Auswahl der jeweils gültigen Kurve) und der gemessenen Batteriespannung eine eindeutige Bestimmung des Ladezustands ermöglichen. Der ermittelte Ladezustand gibt dabei an, wie hoch die nutzbare, zum Zeitpunkt der Messung noch gespeicherte, elektrische Energie der Batterie, bezogen auf die Nennkapazität (in Ah) einer neuen voll aufgeladenen Batterie, noch ist.

Im Anschluß an die Bestimmung des Ladezustands wird nunmehr in einem weiteren Entladeschritt wieder nur für die Dauer von wenigen Sekunden, beispielsweise 5 bis 10 Sekunden, ein hoher Entladestrom, insbesondere der Kälteprüfstrom oder ein Bruchteil des Kälteprüfstroms, insbesondere der halbe Kälteprüfstrom, aus der Batterie gezogen und die dabei erreichte Entladeschlußspannung gemessen, woraufhin anhand der gespeicherten Kurven und der erfindungsgemäß ermittelten Spannungsdifferenz sofort der Verlust der Startfähigkeit bzw. die noch verbliebene Startfähigkeit angezeigt werden kann, und zwar als relativer Startfähigkeitsverlust bzw. prozentuale Startfähigkeit, bezogen auf eine neue Batterie gleichen Ladezustands, was erfindungsgemäß dadurch ermöglicht wird, daß zunächst der Ladezustand genau bestimmt wird. Die Anzeige kann dabei in beliebiger Weise, insbesondere digital und/oder durch Ausdruck eines die relevanten Daten enthaltenden Prüfprotokolls erfolgen. Vorzugsweise werden die Meßergebnisse jedoch mit einer Vorrichtung zum Aufzeichnen von Schreibspuren ausgegeben, die ähnlich arbeitet wie die Aufzeichnungseinrichtungen bekannter Kompressionsdruck-Meßeinrichtungen. Eine derartige Vorrichtung ist in einer früheren Anmeldung der Anmelderin (DE-40 03 713 A1) detailliert beschrieben. Auf jeden Fall wird auf diese Weise eine sehr zuverlässige Angabe darüber erhalten, ob die Batterie bei einer bestimmten Minustemperatur von beispielsweise -18°C überhaupt noch eine ausreichende Spannung für den Anlasser liefern und damit einen problemlosen Start des Kraftfahrzeugs ermöglichen würde. Zusätzlich kann angezeigt oder ausgedruckt werden. in welchem Ausmaß die Kapazität der zu prüfenden Batterie gegenüber der Nennkapazität einer neuen Batterie altersbedingt abgesunken ist.

Insgesamt wird beim Arbeiten nach dem erfindungsgemäpen Verfahren die Möglichkeit geschaffen, unabhängig vom Ausgangszustand der Batterie bereits nach 6 bis 8 Minuten ein abgeschlossenes Prüfungsergebnis vorlegen zu können, aus dem sich sowohl der aktuelle Ladezustand als auch der Verlust der Startfähigkeit bzw. die Startfähigkeit bei der gegebenen Temperatur und ggf. die Kaltstartfähigkeit, z.B. bei -18°C, ergeben.

Zur Durchführung des erfindungsgemäßen Verfahrens hat sich ein Batterieprüfgerät als vorteilhaft erwiesen, welches durch folgende Elemente gekennzeichnet ist:

Spannungsmeßeinrichtungen, Temperaturmeßeinrichtungen, Speichereinrichtungen, in denen die temperaturabhängigen Ladezustandskurven für einen vorgegebenen, relativ niedrigen Entladestrom und einen vorgegebenen hohen Entladestrom sowie die Daten einer dem Verlust der Startfähigkeit zugeordneten Startfähigkeitsverlustkurve für mindestens einen Batterietyp gespeichert sind, Vergleichseinrichtungen zum Vergleichen einer gemessenen Batteriespannung mit den in den Speichereinrichtungen abgelegten Daten der Ladezustandskurven und zum Bestimmen der Differenz zwischen dem Wert der gemessenen Entladeschlußspannung und einem Spannungswert, welcher gemäß den in den Speichereinrichtungen abgelegten Daten einer Ladezustandskurvenschar für eine neuwertige Batterie, ausgehend von dem am Ende des zweiten Entladeschrittes ermittelten Ladezustand, bei der am Ende des zweiten Entladeschrittes ermittelten Temperatur und bei einer Entladung mit dem genau vorgegebenen hohen, konstanten dritten Entladestrom gelten würde, und Auswerteeinrichtungen zum Auswerten der gemessenen Differenz anhand der Startfähigkeitskurve sowie Entladeeinrichtungen zum Entladen der Batterie für vorgegebene Zeitintervalle und mit vorgegebener konstanter Entladestromstärke und Ausgabeeinrichtungen zur Ausgabe von Informationen über den Ladezustand und den Startfähigkeitsverlust der geprüften Batterie.

Ein wichtiger Bestandteil des erfindungsgemäßen Batterieprüfgeräts sind die Speichereinrichtungen, speziell ein Festwertspeicher, insbesondere in Form eines Halbleiterspeichers, mit ein oder mehreren Speichereinheiten zum Speichern der verschiedenen, für die Durchführung des erfindungsgemäßen Verfahrens erforderlichen Kurven in Form einzelner Punkte dieser Kurven bzw. in Form von Koordinatenwerten für die Kurvenpunkte. Insbesondere können die Speichereinrichtungen bzw. der Festwertspeicher zumindest teilweise Bestandteil eines Mikroprozessors bzw. -controllers sein, der gleichzeitig die Vergleichsschaltung und die Differenzmeßeinrichtung sowie die Auswerteeinrichtungen umfaßt und vorzugsweise zumindest teilweise Steuereinrichtungen umfaßt, die nach Eingabe eines Startsignals automatisch für die Durchführung der einzelnen Schritte des erfindungsgemäßen Verfahrens sorgen.

Ein besonderer Vorteil der Realisierung des Festwertspeichers in Verbindung mit einem Mikroprozessor besteht dabei zusätzlich darin, daß mit Hilfe der im Mikroprozessor vorhandenen Recheneinrichtungen anhand der für bestimmte Kurvenpunkte gespeicherten Daten für die gemessenen Spannungen und Temperaturwerte durch Interpolation zusätzlich genaue Kurvenpunkte bestimmt werden können, so daß das Batterieprüfgerät entsprechend exakte Prüfwerte berechnen bzw. anzeigen kann.

Da für die Erzielung genauer Prüf- bzw. Meßwerte eine exakte Bestimmung der Batterietemperatur sehr wichtig ist, hat es sich in Ausgestaltung der Erfindung ferner als vorteilhaft erwiesen, wenn die Temperatur sehr genau gemessen wird, was in Ausgestaltung der Erfindung dadurch ermöglicht wird, daß die Temperaturmeßeinrichtungen einen Temperaturfühler mit einem an eine Außenfläche einer Batteriewand anlegbaren Meßkopf aufweisen, in dem zwei Temperatursensoren, insbesondere in Form von NTC-Widerständen vorgesehen sind, wobei der eine dieser Widerstände an der Rückseite einer relativ großen, aber leichten Metallplatte angebracht ist, deren Vorderseite der Batteriewand mit geringem, vorgegebenem Abstand gegenüberliegt, während der andere Widerstand derart angeordnet ist, daß er von der Umgebungsluft umströmt wird und die Raumtemperatur mißt und wobei die Batterietemperatur mittels Vergleichseinrichtungen in Abhängigkeit von den Ausgangssignalen der beiden NTC-Widerstände und in Abhängigkeit von in den Speichereinrichtungen gespeicherten Meßkurven ermittelt wird.

Es hat sich gezeigt, daß mit einem Temperaturfühler der vorstehend beschriebenen Art sehr genaue und gut reproduzierbare Temperaturmessungen durchgeführt werden können, was darauf zurückzuführen ist, daß der Einfluß der Umgebungstemperatur auf den die Batterietemperatur messenden Temperatursensor in Abhängigkeit vom Ausgangssignal des zweiten Temperatursensors kompensiert werden kann, welcher allein durch die Umgebungstemperatur am Ort des Temperaturfühlers beeinflußt wird. Da bei dem erfindungsgemäßen Batterieprüfgerät ohnehin entsprechende Speicher-, Rechen- und Vergleichseinrichtungen vorhanden sind, hält sich der zusätzliche technische Aufwand für die exakte Temperaturbestimmung dabei in sehr engen Grenzen.

Wenn die prinzipiell hohe Genauigkeit des erfindungsgemäßen Verfahrens bzw. des Batterieprüfgeräts gemäß der Erfindung voll genutzt werden soll, ist es ferner vorteilhaft, wenn die zu prüfende Batterie mit dem Batterieprüfgerät über ein Anschlußkabel einer Batterieklemme verbindbar ist, welche auf der einen Seite des Zungenmauls ein erstes Kontaktstück aufweist, welches mit einem für einen hohen Entladestrom ausgelegten Stromleiter des Anschlußkabels verbunden ist, und welche auf der gegenüberliegenden Seite des Zungenmauls mindestens ein weiteres Kontaktelement aufweist, welches mit zwei weiteren Leitern des Anschlußkabels verbunden ist, die mit einem Speisespannungsanschluß bzw. einem Batteriespannungs-Meßanschluß des Batterieprüfgeräts verbunden sind.

Durch die Verwendung separater Stromleiter für die abzuzweigende Speisespannung, für die Meßspannung und für den zu Prüfzwecken aus der Batterie gezogenen Strom wird vermieden, daß Spannungsverluste und temperaturbedingte Widerstandsänderungen in den für den Batteriestrom und die Versorgungsspannung vorgesehenen Stromleitern die gemessene Batteriespannung verfälschen und damit zu einer Reduzierung der Genauigkeit der Meßergebnisse führen können.

In Ausgestaltung der Erfindung hat es sich ferner als vorteilhaft erwiesen, wenn zumindest während des dritten Entladeschrittes der vorgegebene hohe Entladestrom mit Hilfe eines oder mehrerer Präzisions-Festwiderstände genau bestimmt wird. Dabei besteht in vorteilhafter Ausgestaltung der Erfindung die Möglichkeit, Entladestromeinstelleinrichtungen vorzusehen, welche ein Widerstandsnetzwerk aus mehreren, nach Art einer Widerstandsdekade ausgewählten Widerständen umfassen, so daß mit den verschiedenen Widerstandskombinationen jeweils genau der gewünschte Widerstandswert im Entladestromkreis eingestellt werden kann und damit letztlich ein sehr genauer, konstanter Wert des aus der Batterie abgezogenen Entladestroms. Der Einsatz derartiger Entladestromeinstelleinrichtungen mit Festwiderständen ermöglicht also das Einstellen konstanter Entladeströme sowie die Einstellung des jeweiligen Entladestroms entsprechend dem im Einzelfall zu prüfenden Batterietyp.

Weitere Einzelheiten und Vorteile der Erfindung werden nachstehend anhand von Zeichnungen noch näher erläutert. Es zeigen:

Fig. 1     eine schematische Darstellung zur Erläuterung des Verfahrensablaufs bei dem erfindungsgemäßen Prüfverfahren;

Fig. 2     eine Ladezustandskurvenschar für eine Starterbatterie bei Entladung derselben mit dem Entlade-Nennstrom;

Fig. 3     eine Ladezustandskurvenschar für eine Starterbatterie bei Entladung derselben mit dem Kälteprüfstrom;

Fig. 4     ein vereinfachtes Blockschaltbild eines Batterieprüfgeräts gemäß der Erfindung;

Fig. 5     eine bevorzugte Ausführungsform eines Temperaturfühlers zum Messen der Batterietemperatur in einer Seitenansicht (Fig. 5a) in einer Außenansicht (Fig. 5b) und in einen Teil-Querschnitt (Fig. 5c); und

Fig. 6     eine Seitenansicht einer Batterieklemme zur Verwendung in Verbindung mit einem erfindungsgemäßen Batterieprüfgerät.

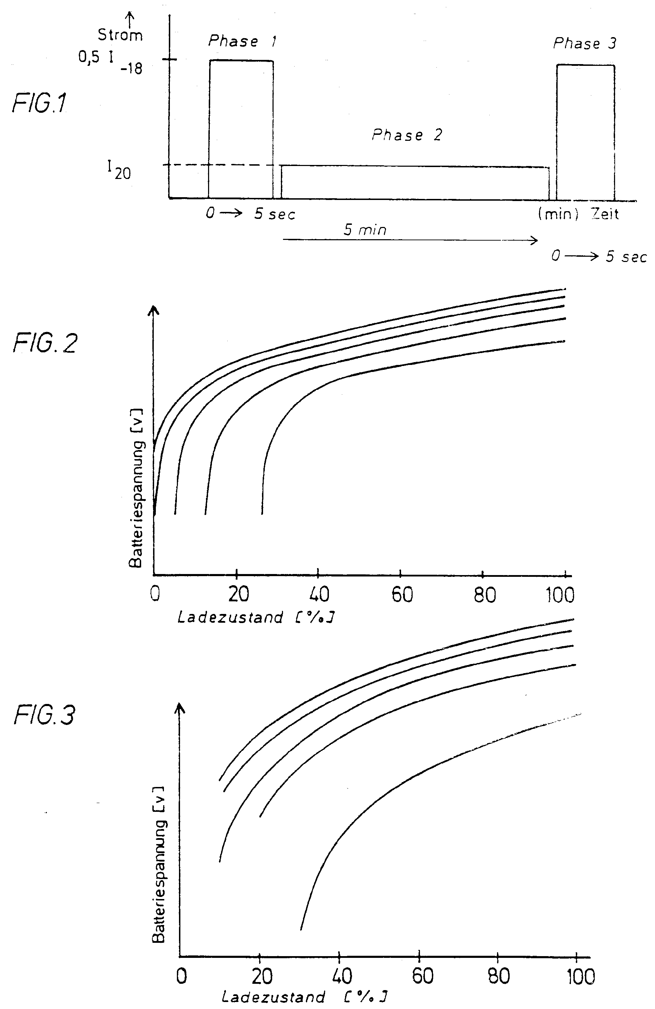

Im einzelnen zeigt Fig. 1 eine schematische Darstellung zur Erläuterung des erfindungsgemäßen Verfahrens bei der Prüfung einer Batterie. Bei der Darstellung gemäß Fig. 1 handelt es sich im Prinzip um ein Strom/Zeit-Diagramm, wobei jedoch zu beachten ist, daß die Zeitachse nicht in einem einheitlichen Maßstab dargestellt ist, da dies im Hinblick auf die kurzen Prüfphasen von wenigen Sekunden einerseits und die deutlich längere Prüfphase von mehreren Minuten andererseits praktisch nicht gut möglich wäre.

Man erkennt, daß erfindungsgemäß während eines ersten Entladeschrittes - Phase 1 - während des Zeitintervalls von 0 bis 5 Sekunden ein hoher Entladestrom, nämlich der halbe Kälteprüfstrom $(0,5\,I_{-18})$, fließt. Während eines zweiten Entladeschrittes - Phase 2 - fließt für die Dauer eines auf das erste Zeitintervall folgenden Zeitintervalls von 5 Minuten (beim Ausführungsbeispiel) ein im Vergleich zum Kälteprüfstrom relativ niedriger Strom, nämlich der auf die Kapazität der zu prüfenden Batterie abgestimmte Entlade-Nennstrom $I_{20}$, d.h. der Strom, der bei der Nennkapazität $K_{20}$ in Ah gemäß folgender Formel:

$$\frac{K_{20}}{Ah} = \frac{I_{20}}{A} \times 20$$

in 20 Stunden die Batterie bis zu einer festgelegten Entladeschlußspannung (10,5 V bei 27°C) entlädt.

Während eines anschließenden, dritten Entladeschrittes - Phase 3 - fließt für ein Zeitintervall von 5 Sekunden gemäß Fig. 1 erneut der halbe Kälteprüfstrom $I_{-18}$. Während der ersten Phase, die dazu dient, das Auftreten des sogenannten Spannungssackes zu verhindern, wird zusätzlich geprüft, ob die Batterie testfähig ist. Sofern die Spannung unter einen Grenzwert abfällt, wird signalisiert, daß die Batterie zunächst geladen werden muß. Im übrigen werden keine Meßergebnisse festgehalten. Am Ende der zweiten Phase wird die Batteriespannung gemessen, die nunmehr unabhängig von der Vorgeschichte der Starterbatterie im wesentlichen der Ruhespannung entspricht und anhand der nachstehend noch zu erläuternden Ladezustandskurven in Verbindung mit der gleichzeitig gemessenen Temperatur die Bestimmung des Ladezustands der Batterie ermöglicht. Während der dritten Phase wird die Batterie dann mit einem hohen Prüfstrom belastet, der je nach dem Batteriezustand zu einem mehr oder weniger starken Abfall der Batteriespannung führt, die am Ende der dritten Phase als Entladeschlußspannung gemessen wird. Im Prinzip könnten entsprechende Kurvenscharen auch unter Verwendung fester Widerstände ermittelt und für die Messungen benutzt werden.

Bei der Durchführung des erfindungsgemäßen Verfahrens in Übereinstimmung mit der schematischen Darstellung gemäß Fig. 1 ist die Stromstärke des Entladestroms in der Phase 1 verhältnismäßig unkritisch und kann ggf. mit abnehmender Batteriespannung abnehmen, da es in dieser Phase des Entladevorgangs allein darauf ankommt, daß der Batterie eine Mindestladungsmenge entnommen wird, die ausreichend ist, um für den Fall einer vorausgegangenen Aufladung der Batterie den sogenannten Spannungssack auszugleichen. Es geht also allein darum, eine Verfälschung der Meßergebnisse am Ende des zweiten Entladeschrittes aufgrund des sogenannten Spannungssackes bzw. aufgrund von Polarisationserscheinungen zu verhindern. Zur Erreichung dieses Ziels ist es erforderlich, der Batterie während der Phase 1 eine Ladungsmenge zu entziehen, die etwa gleich der Ladungsmenge ist, die der Batterie innerhalb eines Zeitintervalls von etwa 5 Minuten bei Fließen des Entlade-Nennstroms $I_{20}$ gemäß der vorstehend angegebenen Gleichung entnommen wird, wobei dieser Strom gelegentlich auch als "zwanzigstündiger Entlade-Nennstrom" bezeichnet wird.

Während der sich an diese "Vorentladung" anschließenden Entladeschritte entsprechend Phase 2 und Phase 3 in Fig. 1 ist es dagegen außerordentlich wichtig, daß die jeweils vorgegebenen Entladeströme sehr genau konstant gehalten werden, da nur in diesem Fall exakte Werte für den Ladezustand und den Startfähigkeitsverlust erhalten werden können. Die gespeicherten Kurven gelten nämlich, wie dies nachstehend noch näher ausgeführt werden wird, nur dann, wenn einer Batterie bei konstantem Strom während eines genau vorgegebenen Zeitintervalls eine exakt vorgegebene Ladungsmenge entnommen wird.

Bei einer Hochleistungsbatterie mit einer Nennkapazität von 63 Ah betragen die Ströme während der Phasen 1, 2 und 3 beispielsweise 190 A, 3 A und 190 A.

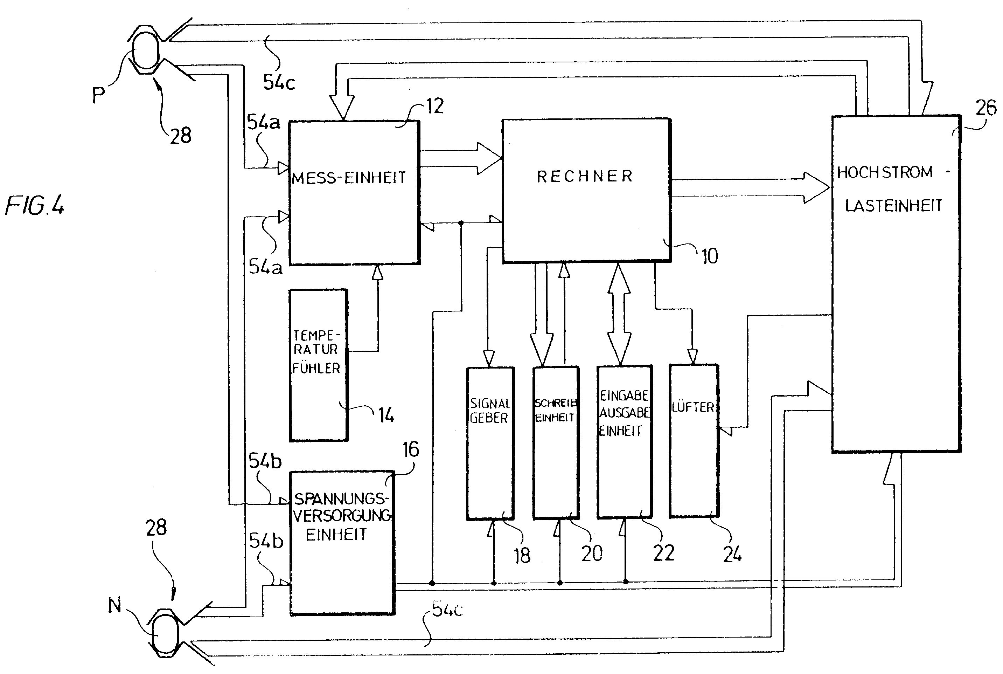

Die Bedeutung der gemessenen Batteriespannungen und deren Auswertung in Abhängigkeit von der gemessenen Batterietemperatur wird nachstehend anhand von Fig. 2 und 3 näher erläutert.

Im einzelnen zeigt Fig. 2 eine Schar von Ladezustandskurven, von denen jede jeweils für eine bestimmte Batterietemperatur einer zu prüfenden Starterbatterie gilt und die insgesamt für Standard-Starterbatterien gelten, die mit dem Nenn-Entladestrom $I_{20}$ entladen werden, wobei auf der Abszisse der Ladezustand in Prozent bezogen auf die Nennkapazität der Batterie bei 27°C aufgetragen ist, während längs der Ordinate die Spannung in V aufgetragen ist. Ähnliche Kurven lassen sich auch für sogenannte hochstromoptimierte Batterien ermitteln.

Wenn nun bei Durchführung des erfindungsgemäßen Verfahrens am Ende des zweiten Entladeschrittes eine bestimmte Batteriespannung und eine bestimmte Batterietemperatur gemessen werden, dann läßt sich anhand der Kurvenschar, ggf. unter Anwendung eines geeigneten Interpolationsverfahrens direkt der relative Ladezustand der geprüften Batterie ablesen. Wenn die Daten der Kurvenschar gemäß der Erfindung in Speichereinrichtungen gespeichert sind, dann kann anhand der gemessenen Temperatur zunächst eine bestimmte Kurve aus dieser Kurvenschar ausgewählt werden, woraufhin dann anhand der gemessenen Batteriespannung ein bestimmter Punkt dieser Kurve - ggf. wieder durch Interpolation - ermittelt und zu diesem Punkt der entsprechende (relative) Ladezustand festgestellt wird. Vorzugsweise erfolgt die Interpolation zweidimensional derart, daß die genauen Koordinaten für jeden Punkt ermittelt werden können, für den bei einer bestimmten Batterietemperatur eine bestimmte Batteriespannung gemessen wurde.

Fig. 3 zeigt ebenfalls eine Schar von Ladezustandskurven, bei der längs der Abszisse der Ladezustand in Prozent und längs der Ordinate die Batteriespannung in V angegeben sind. Die in Fig. 3 für verschiedene Batterietemperaturen dargestellten Ladezustandskurven gelten für eine Standard-Starterbatterie, die für die Dauer von 10 Sekunden mit dem Kälteprüfstrom entladen wird, wobei der prozentuale Ladezustand, bezogen auf die Nennkapazität des geprüften Batterietyps bei 27°C angegeben ist. Den Kurven gemäß Fig. 3 läßt sich bei bekanntem, relativem Ladezustand und bekannter Batterietemperatur - diese Werte werden bei dem erfindungsgemäßen Verfahren am Ende des zweiten Entladeschrittes ermittelt - die nach der Entladung mit dem Kälteprüfstrom für die Dauer von 10 Sekunden zu erwartende Entladeschlußspannung entnehmen. Beim Arbeiten nach dem erfindungsgemäßen Verfahren wird die zu erwartende Entladeschlußspannung, ausgehend vom zuvor ermittelten Ladezustand, aufgrund der in den Speichereinrichtungen gespeicherten Kurvendaten ermittelt, wobei im Prinzip ebenso vorgegangen wird wie bei der anhand von Fig. 2 erläuterten Ermittlung des relativen Ladezustands. Für die Kurvenscharen gemäß Fig. 2 und 3 gilt dabei, daß die einzelnen Kurven von unten nach oben jeweils für eine höhere Batterietemperatur gelten.

Eine Startfähigkeitsverlustkurve verknüpft nun die Spannungsdifferenz, die sich zwischen der am Ende des dritten Entladeschrittes gemessenen Entladeschlußspannung und der anhand der Kurven gemäß Fig. 3 in der vorstehend beschriebenen Weise ermittelten zu erwartenden Entladeschlußspannung ergibt, mit dem relativen Verlust an Startfähigkeit in Prozent. Der aus der Startfähigkeitsverlustkurve bestimmte relative Verlust der Startfähigkeit bezieht sich dabei auf eine neuwertige Batterie, die den gleichen Ladezustand hat, der für die geprüfte Batterie am Ende des zweiten Ladeschrittes ermittelt wurde. Auch der relative Startfähigkeitsverlust aufgrund von Ladezustand und Alter gegenüber einer voll geladenen neuen Batterie kann ermittelt werden. Im übrigen erfolgt die Verknüpfung der Meßdaten mit den gespeicherten Daten der Startfähigkeitsverlustkurve wieder in entsprechender Weise wie im Zusammenhang mit Fig. 2 erläutert.

Nachdem vorstehend das Prinzip einer Batterieprüfung nach dem erfindungsgemäßen Verfahren ausführlich erläutert wurde, soll nachstehend anhand des Blockschaltbildes gemäß Fig. 4 näher auf die technische Realisierung eines Prüfgeräts zur Durchführung eines erfindungsgemäßen Verfahrens eingegangen werden.

Im einzelnen zeigt Fig. 4 ein vereinfachtes schematisches Blockschaltbild eines Batterieprüfgeräts gemäß der Erfindung einschließlich einer die zu prüfende Batterie mit dem eigentlichen Prüfgerät verbindenden Batterieklemmen und der der Ermittlung der Batterietemperatur dienenden Temperaturmeßeinrichtungen.

Das in Fig. 4 gezeigte Batterieprüfgerät umfaßt als zentrale Baugruppe einen Rechner 10, beispielsweise einen Mikrocontroller des Typs SAB 80 535 der Firma Siemens (mit separatem Halbleiterspeicher). Ein derartiger Rechner bzw. Mikrocontroller umfaßt von Hause aus die für die Durchführung des erfindungsgemäßen Verfahrens erforderlichen Rechen-, Speicher- und Vergleichseinrichtungen sowie Steuereinrichtungen, mit deren Hilfe ein automatischer Ablauf des Prüfverfahrens bzw., genauer gesagt, eine automatische Steuerung des Ablaufs der einzelnen Schritte des erfindungsgemäßen Prüfverfahrens, durchgeführt werden kann. In den Speichereinrichtungen des Rechners 10, insbesondere einem oder mehreren Festwertspeichern in Form geeigneter Halbleiterspeicher, sind die für die Durchführung des erfindungsgemäßen Verfahrens erforderlichen Daten gespeichert, nämlich die Daten der Kurvenschar gemäß Fig. 2, die Daten der Kurvenschar gemäß Fig. 3, die Daten der Startfähigkeitsverlustkurve sowie vorzugsweise zusätzliche Daten, wie z.B. die Daten von Kompensationskurven für die Temperaturmessung, die Daten ein oder mehrerer Steuerprogramme und die Daten gerätespezifischer Eichtabellen.

Der Rechner 10 ist mit einer zu den Spannungsmeßeinrichtungen gehörenden Meßeinheit 12 verbunden, die ihrerseits mit einem Temperaturfühler 14 verbunden ist. Weiterhin sind mit dem Rechner 10 eine Spannungsversorgungseinheit 16, ein Signalgeber 18, eine Schreibeinheit 20, eine Eingabe/Ausgabe-Einheit 22, ein Lüfter 24 und, als Bestandteil der Entladestromeinstelleinrichtungen, eine Hochstrom-Lasteinheit 26 verbunden. Von den genannten Baugruppen bzw. Einheiten sind die Meßeinheit 12, die Spannungsversorgungseinheit 16 und die Hochstrom-Lasteinheit 26 über Batterieklemmen 28 mit dem positiven Pol P bzw. dem negativen Pol N einer zu prüfenden Batterie (nicht gezeigt) verbunden. Ferner ist der Temperaturfühler 14 in nachstehend noch näher zu beschreibender Weise an einer der Batteriewände der zu prüfenden Batterie angeordnet.

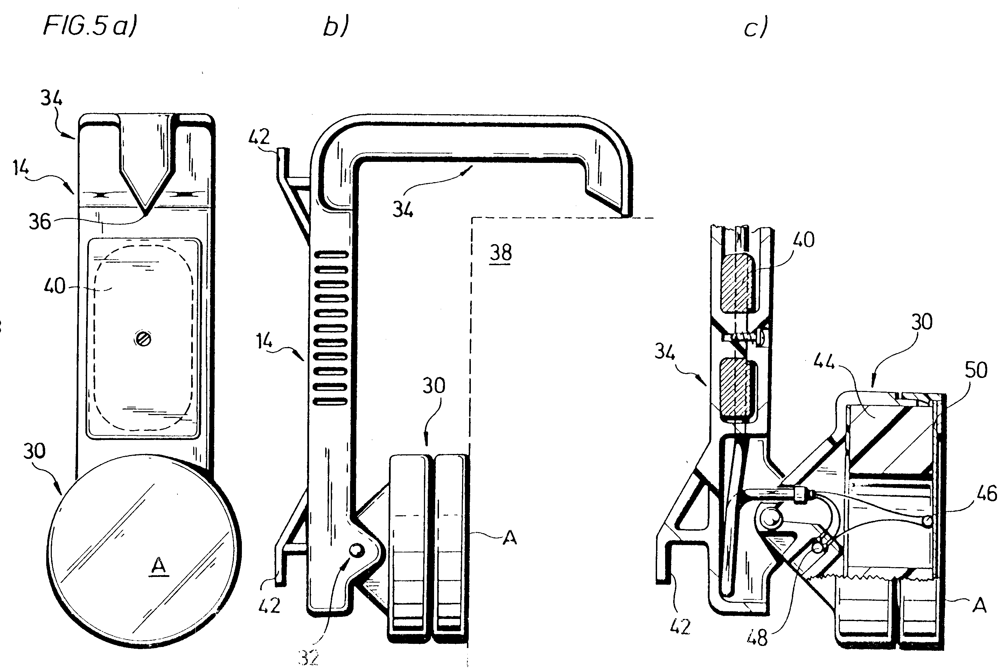

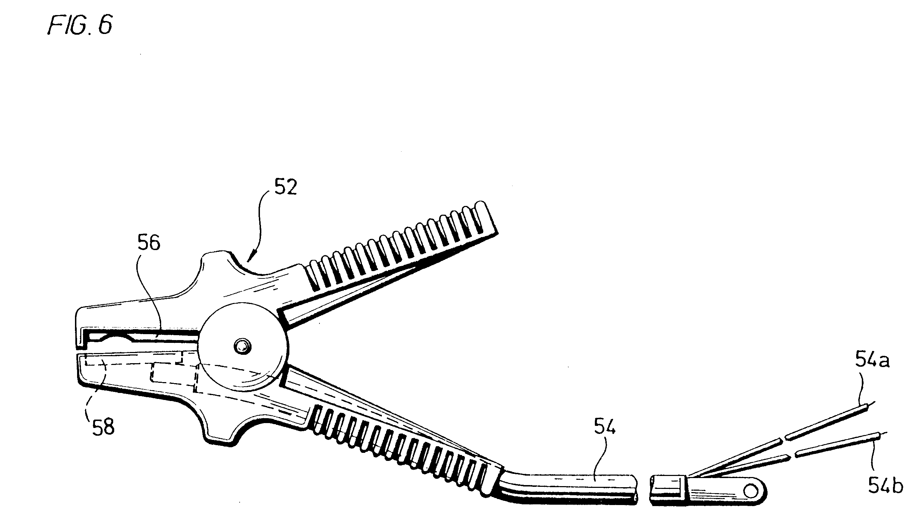

Ehe nachstehend näher auf die Funktion des Batterieprüfgeräts gemäß Fig. 4 eingegangen wird, sollen zuvor anhand von Fig. 5 und 6 der Zeichnungen noch bevorzugte Ausführungsformen eines Temperaturfühlers und einer Batterieklemme für ein erfindungsgemäßes Batterieprüfgerät näher erläutert werden.

Im einzelnen zeigt Fig. 5 mit ihren Teilfiguren 5a bis 5c einen Temperaturfühler 14 mit einem Meßkopf 30, welcher über eine Gelenkverbindung 32 an einem bügelförmigen Träger 34 angelenkt ist. Der Träger 34 besitzt eine Spitze 36, mit der er im Gebrauch auf die Oberseite einer zu prüfenden Batterie 38 aufgesetzt wird, deren Umriß durch eine gestrichelte Linie c angedeutet ist. Durch die gelenkige Anbringung des Meßkopfes 30 am Träger 34 ist es möglich, daß sich der Meßkopf 30 bei der beschriebenen Ausgestaltung des Temperaturfühlers mit seiner aktiven Fläche A jeweils genau an die Außenfläche der benachbarten Batteriewand anlegt. Da der Schwerpunkt des Meßfühlers seitlich gegenüber dem Abstützpunkt versetzt ist, an dem die Spitze 36 des Trägers 34 an der Oberseite der Batterie 38 anliegt, ist dabei im Bereich des Meßkopfes 30 stets eine Kraftkomponente vorhanden, die das Anliegen der aktiven Fläche A an der Außenfläche der Batteriewand erzwingt. Die Kraft, mit der die aktive Fläche A des Meßkopfes 30 an der Batteriewand anliegt, kann dabei in vorteilhafter Ausgestaltung der Erfindung dadurch erhöht werden, daß im senkrechten Teil des Trägers 34, angrenzend an den Meßkopf 30, ein Gewicht 40 angeordnet wird, wie dies besonders aus Fig. 5c deutlich wird. Der Träger 34 des Meßfühlers 14 ist vorzugsweise als Kunststofformteil ausgebildet und auf seiner von dem Meßkopf 30 abgewandten Rückseite mit Ansätzen 42 zum Aufwickeln einer Signalleitung (nicht gezeigt) versehen.

Wie aus dem Teilquerschnitt gemäß Fig. 5c deutlich wird, ist an der aktiven Fläche A des Meßkopfes 30 eine Platte 50 vorgesehen, die möglichst dünn und leicht sein soll und beispielsweise aus Aluminiumblech bestehen kann. Besonders bevorzugt wird jedoch eine dünne Edelstahlplatte 50, da diese von der Batteriesäure nicht angegriffen wird. Ein Distanzring 44, welcher die Platte 50 auf ihrem äußeren Umfang umgibt, sorgt für den richtigen Abstand zwischen Batteriewand und Platte 50 und schließt ein definiertes Luftvolumen ein. An der Rückseite der Platte 50 ist in einem geschlossenen Gehäuse ein erster Sensor 46, insbesondere in Form eines NTC-Widerstandes angeordnet. Ein zweiter Sensor 48, welcher vorzugsweise ebenfalls als NTC-Widerstand ausgebildet ist, liegt in einer nach außen offenen Vertiefung des Meßkopfgehäuses und wird von der Umgebungsluft umströmt. Von den beiden Sensoren 46, 48 führt eine Signalleitung zu der Meßeinheit 12.

Fig. 6 zeigt eine bevorzugte Ausführungsform einer Batterieklemme zur Verwendung in Verbindung mit dem Batterieprüfgerät gemäß Fig. 4. Die Batterieklemme 28 umfaßt eine in üblicher Weise mit einer isolierenden Ummantelung versehene Zange 52, die im Gebrauch einerseits auf dem zugehörigen Batteriepol P bzw. N festgeklemmt ist und andererseits über ein Kabel 54 an das Batterieprüfgerät gemäß Fig. 4 angeschlossen ist. Die Besonderheit der erfindungsgemäßen Batterieklemme gemäß Fig. 6 besteht darin, daß im Bereich des Zangenmauls zwei elektrisch vollkommen voneinander getrennte Kontaktstücke 56, 58 vorgesehen sind, die auf gegenüberliegenden Seiten des Zangenmauls angeordnet sind. Ferner ist das Kabel 54 als dreiadriges Kabel ausgeführt.

Beim Ausführungsbeispiel ist das eine Kontaktstück 26 mit zwei Adern 54a, 54b des Kabels verbunden, die einen relativ geringen Querschnitt von beispielsweise 1,5 mm² besitzen. Ein dritter Leiter 54c des Kabels 54, welcher einen großen Querschnitt von beispielsweise 35 mm² ist mit dem anderen Kontaktstück 58 verbunden. Der Zweck der Trennung der Kontaktstücke 56 und 58 und der Verwendung dreier separater und gegeneinander isolierter Adern bzw. Leitungen 54a bis 54c des Kabels 54 besteht darin, eine Beeinflussung der gemessenen Batteriespannung durch den Laststrom über die Ader 54c und den Versorgungsstrom für das Batterieprüfgerät, welcher über die Ader 54b fließt, zu vermeiden, so daß die gemessene Batteriespannung über die Ader 54a mit hoher Genauigkeit gemessen werden kann.

Wie aus Fig. 4 deutlich wird, sind die für den Laststrom vorgesehenen dicken Adern 54c der beiden Batterieklemmen 28 jeweils direkt mit der Hochstrom-Lasteinheit 26 verbunden. Die Adern 54b führen von den beiden Batteriepolen P und N zu der Spannungsversorgungseinheit 16. Die Adern 54a beider Batterieklemmen 28 sind schließlich direkt mit der Meßeinheit 12 verbunden.

Bei der Durchführung einer Batterieprüfung mit dem Batterieprüfgerät gemäß Fig. 4 werden zunächst die Batterieklemmen 28 bzw. deren Zangen 52 an den beiden Batteriepolen P und N angebracht. Ferner wird der Temperaturfühler 14 in der anhand von Fig. 5 erläuterten Weise derart an der zu prüfenden Batterie angebracht, daß der Meßkopf an der Außenfläche einer Batteriewand anliegt Nachdem diese Vorbereitungen abgeschlossen sind, können an der Eingabeeinheit 22 über die dort vorgesehene Tastatur die Angaben über die Nennkapazität und den Batterietyp der zu prüfenden Batterie eingegeben werden. Anschließend wird - vorzugsweise beim Einlegen einer Karte für die eingangs erwähnte Vorrichtung zum Aufzeichnen von Schreibspuren - ein Startbefehl eingegeben. Unter Steuerung durch den Rechner 10 laufen nunmehr die einzelnen Schritte des erfindungsgemäßen Verfahrens nacheinander automatisch ab. Dabei wird die an den Batterieklemmen P und N über die Leitungen 54a abgegriffene Spannung ständig der Meßeinheit zugeführt, welche außerdem kontinuierlich ein Ausgangssignal des Temperaturfühlers empfängt. Von der Meßeinheit werden die eingangsseitigen Signalspannungen in geeigneter Weise aufbereitet und als normierte Spannungen, bei anderen Prozessoren gegebenenfalls in Form digitalisierter Signale, zu dem Rechner 10 übertragen. Die einzelnen Meßergebnisse werden, soweit erforderlich, in den Speichereinrichtungen zwischengespeichert, ehe sie an der Ausgabeeinheit 20 in geeigneter Form ausgegeben werden. Dabei ist die kontinuierliche Messung der Batteriespannung während der Phasen 2 und 3 des erfindungsgemäßen Prüfverfahrens besonders wichtig, da anhand der gemessenen Batteriespannung die Widerstandskombinationen der Hochstrom-Lasteinheit 26 in geeigneter Weise zusammengestellt werden müssen, um die Entladeströme für die Dauer der jeweiligen Prüfungsphasen genau konstant zu halten. Am Ende eines Prüfzyklus werden die ermittelten Daten über die Ausgabeeinheit 20 ausgegeben. Während des Prüfzyklus dient der Signalgeber 18 dazu, aufgetretene Fehler durch Pfeiftöne und/oder Blinksignale zu signalisieren. Ferner zeigt der Signalgeber das Arbeiten des Batterieprüfgeräts und ggf. das Ende eines Prüfzyklus an. Der Lüfter 24 des erfindungsgemäßen Prüfgeräts wird ebenfalls durch den Rechner 10 gesteuert, um speziell während der Hochstromentladephasen für eine ausreichende Kühlung der Hochstrom-Lasteinheit 26 zu sorgen. Dabei wird der Lüfter 24 während der Meßphasen mit einem exakt vorgegebenen, konstanten Strom gespeist, wobei dieser Strom bei der Ermittlung des Ladezustands und des Startfähigkeitsverlustes mitberücksichtigt wird. Die Spannungsversorgungseinheit 16 sorgt während des Betriebes des Batterieprüfgeräts für die Speisung der einzelnen Baugruppen mit vorgegebenen, stabilisierten Speisespannungen und liefert ggf. erforderliche Referenzspannungen, wobei die Spannungsversorgungseinheit 16 vorzugsweise mit einem Verpolungsschutz ausgestattet ist, damit eine Verpolung der Anschlüsse des Batterieprüfgeräts bezüglich der Batteriepole keine nachteiligen Folgen hat.

Während vorstehend davon ausgegangen wurde, daß in Abhängigkeit von der gemessenen Batteriespannung immer neue Kombinationen von Festwiderständen zusammengeschaltet werden, um den richtigen Widerstandswert für das Konstanthalten des Entladestroms zu erreichen, besteht in Ausgestaltung der Erfindung ferner die Möglichkeit, ein Widerstandsnetzwerk aus mehreren parallelen Zweigen mit jeweils einem Festwiderstand und einem regelbaren Widerstand zu verwenden, so daß mit jedem dieser Zweige jeweils ein gewisser Widerstandsbereich überdeckt werden kann.

## Patentansprüche

1. Verfahren zum Bestimmen des Zustands einer Bleibatterie, insbesondere einer Starterbatterie, bei dem die Batterie für die Dauer eines begrenzten Zeitintervalls mit einem Entladestrom entladen wird und bei dem die Entladeschlußspannung am Ende dieses Zeitintervalls zur Bestimmung des Ladezustands der Batterie gemessen wird,
   **mit folgenden Verfahrensschritten:**
   a) in einem ersten Entladeschritt (Phase 1) wird die Batterie für die Dauer einiger Sekunden zum Ausgleich des sogenannten Spannungssackes mit einem hohen ersten Entladestrom entladen;
   b) in einem zweiten Entladeschritt (Phase 2) wird die Batterie (38) anschließend für die Dauer einiger Minuten mit einem vorgegebenen, relativ niedrigen, konstanten, zweiten Entladestrom ($I_{20}$) entladen;
   c) am Ende des zweiten Entladeschrittes werden die Batterietemperatur und die Batteriespannung mit Hilfe von Temperatur- bzw. Spannungsmeßeinrichtungen (12 bzw. 14) gemessen;
   d) in Abhängigkeit von der gemessenen Batterietemperatur und der gemessenen Batteriespannung wird anhand von in Speichereinrichtungen gespeicherten Daten einer ersten Ladezustandskurvenschar der relative Ladezustand der zu prüfenden Batterie, bezogen auf eine voll aufgeladene Batterie dieses Typs, ermittelt;

e) in einem dritten Entladeschritt (Phase 3) wird die Batterie für die Dauer eines Zeitintervalls von einigen Sekunden mit einem genau vorgegebenen hohen, konstanten, dritten Entladestrom entladen;

f) die bei dem dritten Entladeschritt erreichte Entladeschlußspannung wird mit Hilfe der Spannungsmeßeinrichtungen (12) gemessen;

g) mit Hilfe von Vergleichseinrichtungen (10) wird die Spannungsdifferenz zwischen dem Wert der gemessenen Entladeschlußspannung und einem Spannungswert ermittelt, welcher gemäß den in den Speichereinrichtungen abgelegten Daten einer zweiten Ladezustandskurvenschar für eine neuwertige Batterie (38), ausgehend von dem am Ende des zweiten Entladeschrittes (Phase 2) ermittelten Ladezustand, bei der am Ende des zweiten Entladeschrittes (Phase 2) ermittelten Temperatur und bei einer Entladung mit dem genau vorgegebenen hohen, konstanten dritten Entladestrom gelten würde; und

h) aufgrund der ermittelten Spannungsdifferenz wird anhand der in den Speichereinrichtungen (10) gespeicherten Daten einer dem Verlust der Startfähigkeit des zu prüfenden Batterietyps zugeordneten Kurve der dem Ladezustand entsprechende relative Verlust der Startfähigkeit, bezogen auf eine neuwertige Batterie (38) gleichen Ladezustands, ermittelt bzw. die zum Zeitpunkt der Prüfung noch vorhandene relative Startfähigkeit,

wobei die erste und die zweite Ladezustandskurvenschar vorgegebene Kurven umfassen, die für den zu prüfenden Batterietyp sowie für den zweiten bzw. dritten Entladestrom gelten und die Batteriespannung und den Ladezustand bei den betreffenden Temperaturen miteinander verknüpfen.

2. Verfahren nach Anspruch 1, dadurch gekennzeichnet, daß für den hohen vorgegebenen dritten Entladestrom ein Bruchteil des Kälteprüfstroms, insbesondere der halbe Kälteprüfstrom, gewählt wird.

3. Verfahren nach Anspruch 1, dadurch gekennzeichnet, daß für den niedrigen zweiten Entladestrom im zweiten Entladeschritt ein der Nennkapazität der Batterie zugeordneter Entladenennstrom, insbesondere der 20stündige Entladenennstrom, gewählt wird.

4. Verfahren nach einem der Ansprüche 1 bis 3, dadurch gekennzeichnet, daß für den ersten Entladeschritt ein Zeitintervall bis zu etwa 10 Sekunden, vorzugsweise von 2 bis 5 Sekunden, vorgegeben wird.

5. Verfahren nach einem der Ansprüche 1 bis 4, dadurch gekennzeichnet, daß für den zweiten Entladeschritt ein Zeitintervall bis zu 30 Minuten, vorzugsweise von 3 bis 10 Minuten, vorgegeben wird.

6. Verfahren nach einem der Ansprüche 1 bis 5, dadurch gekennzeichnet, daß für den dritten Entladeschritt ein Zeitintervall bis zu etwa 20 Sekunden, vorzugsweise von etwa 5 Sekunden, vorgegeben wird.

7. Verfahren nach einem der Ansprüche 1 bis 6, dadurch gekennzeichnet, daß in dem Festwertspeicher die Ladezustandskurvenscharen und die Startfähigkeitsverlustkurven mehrerer Batterietypen gespeichert werden und die Information über den zu prüfenden Batterietyp durch Eingabe der Werte für die Nennkapazität und den Kälteprüfstrom des zu prüfenden Batterietyps mittels einer Eingabevorrichtung in eine mit dem Festwertspeicher zusammenwirkende Speichereinrichtung vor der Durchführung der Messungen eingegeben wird.

8. Verfahren nach einem der Ansprüche 1 bis 7, dadurch gekennzeichnet, daß die einzelnen Verfahrensschritte ggf. nach Eingabe der Informationen über den zu prüfenden Batterietyp in Abhängigkeit von einem Startsignal mittels Steuerungseinrichtungen automatisch durchgeführt werden.

9. Verfahren nach einem der Ansprüche 1 bis 8, dadurch gekennzeichnet, daß die Temperaturmessung mit Hilfe der Temperaturmeßeinrichtungen in der Weise durchgeführt wird, daß die Batterietemperatur in Abhängigkeit von einem durch die Umgebungstemperatur beeinflußten Meßwert für die Temperatur und einem allein von der Umgebungstemperatur abhängigen Meßwert bestimmt wird.

10. Verfahren nach Anspruch 9, dadurch gekennzeichnet, daß die Bestimmung der wahren Batterietemperatur mit Hilfe von in einer Speichereinrichtung gespeicherten Temperaturkompensationskurven angenähert wird.

11. Verfahren nach einem der Ansprüche 1 bis 10, dadurch gekennzeichnet, daß die Entladeströme zumindest während des zweiten und dritten Entladeschrittes mit Hilfe von Entladeeinrichtungen konstant gehalten werden, welche Festwiderstände mit in definierter Weise gestaffelten Widerstandswerten umfassen.

12. Verfahren nach Anspruch 11, dadurch gekennzeichnet, daß Toleranzen der Festwiderstände mit Hilfe von in einem Speicher gespeicherten Eichtabellen kompensiert werden.

13. Verfahren nach einem der Ansprüche 1 bis 12, dadurch gekennzeichnet, daß der Batterie während des ersten Entladungsschrittes eine Mindestladungsmenge entnommen wird, die etwa gleich der bei der Entladung der Batterie mit dem zwanzigstündigen Entladestrom innerhalb von 5 Minuten entnommenen Ladungsmenge ist.

14. Batterieprüfgerät zur Durchführung des Verfahrens nach einem der Ansprüche 1 bis 13, mit folgenden Elementen:
Spannungsmeßeinrichtungen (12), Temperaturmeßeinrichtungen (14), Speichereinrichtungen, in denen die temperaturabhängigen Ladezustandskurven für einen vorgegebenen, relativ niedrigen Entladestrom und einen vorgegebenen hohen Entladestrom sowie die Daten einer dem Verlust der Startfähigkeit zugeordneten Startfähigkeitsverlustkurve für mindestens einen Batterietyp gespeichert sind, Vergleichseinrichtungen (10) zum Vergleichen einer gemessenen Batteriespannung mit den in den Speichereinrichtungen abgelegten Daten der Ladezustandskurven und zum Bestimmen der Differenz zwischen dem Wert der gemessenen Entladeschlußspannung und einem Spannungswert, welcher gemäß den in den Speichereinrichtungen (10) abgelegten Daten einer Ladezustandskurvenschar für eine neuwertige Batterie (38), ausgehend von dem am Ende des zweiten Entladeschrittes (Phase 2) ermittelten Ladezustand, bei der am Ende des zweiten Entladeschrittes (Phase 2) ermittelten Temperatur und bei einer Entladung mit dem genau vorgegebenen hohen, konstanten dritten Entladestrom gelten würde, und Auswerteeinrichtungen (10) zum Auswerten der gemessenen Differenz anhand der Startfähigkeitsverlustkurve sowie Entladeeinrichtungen zum Entladen der Batterie (38) für vorgegebene Zeitintervalle und mit vorgegebener konstanter Entladestromstärke und Ausgabeeinrichtungen (22) zur Ausgabe von Informationen über den Ladezustand und den Startfähigkeitsverlust der geprüften Batterie (38).

15. Batterieprüfgerät nach Anspruch 14, dadurch gekennzeichnet, daß Steuereinrichtungen vorgesehen sind, durch die die Elemente des Prüfgeräts nach Eingabe eines Startsignals automatisch zur Durch-führung der einzelnen Schritte des erfindungsgemäßen Verfahrens steuerbar sind.

16. Batterieprüfgerät nach Anspruch 14 oder 15, dadurch gekennzeichnet, daß die Temperaturmeßeinrichtungen einen Temperaturfühler (14) mit einem an eine Außenfläche einer Batteriewand anlegbaren Meßkopf (30) aufweisen, in dem zwei Temperatursensoren (46, 48) vorgesehen sind, daß der eine dieser Temperatursensoren an einer relativ großen, aber leichten Metallplatte angebracht ist, deren Vorderseite der Batteriewand mit geringem, vorgegebenem Abstand gegenüberliegt, daß der andere Temperatursensor derart angeordnet ist, daß er von der Umgebungsluft umströmt wird und die Raumtemperatur mißt und daß die Batterietemperatur mittels Vergleichseinrichtungen in Abhängigkeit von den Ausgangssignalen der beiden Temperatursensoren und in Abhängigkeit von in den Speichereinrichtungen gespeicherten Meßkurven ermittelt wird.

17. Batterieprüfgerät nach Anspruch 16, dadurch gekennzeichnet, daß mindestens einer (46) der Temperatursensoren einen NTC-Widerstand umfaßt.

18. Batterieprüfgerät nach Anspruch 16 oder 17, dadurch gekennzeichnet, daß der Meßkopf (30) auf der Außenseite der Metallplatte (50) einen Distanzring (44) aufweist, mit dessen Hilfe im Betrieb zwischen der Außenseite der Metallplatte und der Außenfläche der ihr gegenüberliegenden Batteriewand für den Meßvorgang ein definiertes, abgeschlossenes Luftvolumen vorgebbar ist.

19. Batterieprüfgerät nach einem der Ansprüche 16 bis 18, dadurch gekennzeichnet, daß die Metallplatte (50) aus rostfreiem Stahl hergestellt ist.

20. Batterieprüfgerät nach einem der Ansprüche 16 bis 19, dadurch gekennzeichnet, daß der Meßkopf (30) im Bereich des unteren Endes eines bügelförmigen Trägers (34) angelenkt ist, dessen freies, vom Meßkopf abgewandtes Ende im Betrieb an der Oberseite der zu prüfenden Batterie abgestützt ist.

**21.** Batterieprüfgerät nach Anspruch 20, dadurch gekennzeichnet, daß der Träger (34) angrenzend an den Meßkopf ein erhöhtes Gewicht aufweist.

**22.** Batterieprüfgerät nach Anspruch 21, dadurch gekennzeichnet, daß der Träger als Kunststofformteil mit einem an dem Meßkopf angeordneten Gewicht ausgebildet ist.

**23.** Batterieprüfgerät nach Anspruch 16 und 17, dadurch gekennzeichnet, daß der an der Metallplatte (50) vorgesehene Widerstand als aus einem Material mit negativem Temperaturkoeffizienten bestehende Perle ausgebildet und insbesondere direkt in eine Öffnung der Metallplatte eingesetzt ist.

**24.** Batterieprüfgerät nach einem der Ansprüche 14 bis 23, dadurch gekennzeichnet, daß die zu prüfende Batterie mit dem Batterieprüfgerät über ein Anschlußkabel mit einer Batterieklemme (28) verbindbar ist, welche auf der einen Seite des Zangenmauls ein erstes Kontaktelement aufweist, welches mit einem für einen hohen Entladestrom ausgelegten Stromleiter des Anschlußkabels verbunden ist und welche auf der gegenüberliegenden Seite des Zangenmauls mindestens ein weiteres Kontaktelement aufweist, welches mit zwei weiteren Leitern des Anschlußkabels verbunden ist, die mit einem Speisespannungsanschluß bzw. einem Batteriespannungs-Meßanschluß des Batterieprüfgeräts verbunden sind.

**25.** Batterieprüfgerät nach einem der Ansprüche 14 bis 24, dadurch gekennzeichnet, daß Entladestromeinstelleinrichtungen vorgesehen sind, welche ein Widerstandsnetzwerk umfassen, das aus mehreren, nach Art einer Widerstandsdekade ausgewählten Festwiderständen aufgebaut ist.

**26.** Batterieprüfgerät nach Anspruch 25, dadurch gekennzeichnet, daß für die Abstufung der Widerstandswerte der Festwiderstände ein Verhältnis von 1 : 2 für jeweils zwei benachbarte Widerstandswerte vorgesehen ist.

**27.** Batterieprüfgerät nach Anspruch 25, dadurch gekennzeichnet, daß für die Abstufung der Widerstandswerte der Festwiderstände die Normalabstufung vorgesehen ist.

**28.** Batterieprüfgerät nach einem der Ansprüche 14 bis 24, dadurch gekennzeichnet, daß Entladestromeinstelleinrichtungen vorgesehen sind, die mehrere parallele Zweige mit jeweils einem Festwiderstand und einem veränderlichen Widerstand umfassen.

## Claims

**1.** Method of determining the state of a lead-acid battery, in particular a starter battery, in which the battery is discharged with a discharge current for the duration of a limited time interval and in which the cut-off voltage at the end of this time interval is measured for determining the state of charge of the battery, comprising the following method steps:

a) in a first discharge step (phase 1), the battery is discharged for the duration of a few seconds to compensate for the so-called transient voltage drop with a high first discharge current;

b) in a second discharge step (phase 2), the battery (38) is subsequently discharged for the duration of a few minutes with a predetermined, relatively low, constant second discharge current ($I_{20}$);

c) at the end of the second discharge step, the battery temperature and the battery voltage are measured with the aid of temperature-measuring and voltage-measuring devices (12 and 14, respectively);

d) in dependence on the measured battery temperature and the measured battery voltage, the relative state of charge of the battery to be tested, with respect to a fully charged battery of this type, is established from data of a first family of state-of-charge curves stored in memory devices;

e) in a third discharge step (phase 3), the battery is discharged for the duration of a time interval of a few seconds with a precisely predetermined high, constant third discharge current;

f) the cut-off voltage achieved in the third discharge step is measured with the aid of the voltage-measuring devices (12);

g) with the aid of comparison devices (10), the voltage difference is established between the value of the measured cut-off voltage and a voltage value which, according to the data of a second family of state-of-charge curves filed in the memory devices, would apply for an as-new battery (38), taking as a basis the state of charge established at the end of the second discharge step (phase 2), at the temperature established at the end of the second discharge step (phase 2) and at a discharge with the

11

precisely predetermined high, constant third discharge current; and

h) on the basis of the established voltage difference, the relative loss of starting capability corresponding to the state of charge, with respect to an asnew battery (38) of the same state of charge, is established from the data of a curve assigned to the loss of starting capability of the battery type to be tested stored in the memory devices (10), or the relative starting capability still existing at the time of the test is established, the first and the second family of state-of-charge curves comprising predetermined curves which apply for the battery type to be tested and for the second and third discharge current, respectively, and link the battery voltage and the state of charge to each other at the temperatures concerned.

2. Method according to Claim 1, characterized in that a fraction of the cold test current, in particular half the cold test current, is chosen for the high predetermined third discharge current.

3. Method according to Claim 1, characterized in that a nominal discharge current assigned to the nominal capacity of the battery, in particular the 20-hour nominal discharge current, is chosen for the low second discharge current in the second discharge step.

4. Method according to one of Claims 1 to 3, characterized in that a time interval of up to about 10 seconds, preferably of 2 to 5 seconds, is predetermined for the first discharge step.

5. Method according to one of Claims 1 to 4, characterized in that a time interval of up to 30 minutes, preferably of 3 to 10 minutes, is predetermined for the second discharge step.

6. Method according to one of Claims 1 to 5, characterized in that a time interval of up to about 20 seconds, preferably of about 5 seconds, is predetermined for the third discharge step.

7. Method according to one of Claims 1 to 6, characterized in that the families of state-of-charge curves and the loss-of-starting-capacity curves of a plurality of battery types are stored in the read-only memory and the information on the battery type to be tested is entered before carrying out the measurements into a memory device interacting with the read-only memory by input of the values for the nominal capacity and the cold test current of the battery type to be tested by means of an input device.

8. Method according to one of Claims 1 to 7, characterized in that the individual method steps are carried out automatically, if appropriate after input of the information on the battery type to be tested, in dependence on a starting signal by means of control devices.

9. Method according to one of Claims 1 to 8, characterized in that the temperature measurement is carried out with the aid of the temperature-measuring devices by the battery temperature being determined in dependence on a measured value for the temperature, influenced by the ambient temperature, and a measured value dependent on the ambient temperature alone.

10. Method according to Claim 9, characterized in that the determination of the true battery temperature is approximated with the aid of temperature-compensation curves stored in a memory device.

11. Method according to one of Claims 1 to 10, characterized in that the discharge currents are kept constant, at least during the second and third discharge step, with the aid of discharge devices which comprise fixed resistors with resistance values staggered in a defined way.

12. Method according to Claim 11, characterized in that tolerances of the fixed resistors are compensated with the aid of calibration tables stored in a memory.

13. Method according to one of Claims 1 to 12, characterized in that, during the first discharge step, a minimum amount of charge, which is approximately equal to the amount of charge taken during the discharge of the battery with the twenty-hour discharge current within 5 minutes, is taken from the battery.

14. Battery tester for carrying out the method according to one of Claims 1 to 13, having the following elements:
voltage-measuring devices (12), temperature-measuring devices (14), memory devices, in which the temperature-dependent state-of-charge curves for a predetermined, relatively low discharge current and a predetermined high discharge current and also the data of a loss-of-starting-capacity curve assigned to the loss of starting capacity for at least one battery type are stored, comparison devices (10) for comparing a measured battery voltage with the data of the state-of-charge curves filed in the memory devices and for determining the difference between the value of the measured cut-off voltage and a voltage value which, according to the data of a family of state-of-charge curves filed in the memory devices (10), would apply for an as-new battery (38), taking as a basis the state of charge established at the end of the second discharge step (phase 2), at the temperature established at the end of the second discharge step (phase 2) and at a discharge with the precisely predetermined high, constant third discharge current, and evaluation devices (10) for evaluating the measured difference from the loss-of-starting-capacity curve and also discharge devices for discharging the battery (38) for predetermined time intervals and with predetermined constant discharge current intensity, and output devices (22) for the output of information on this state of charge and the loss of starting capacity of the tested battery (38).

15. Battery tester according to Claim 14, characterized in that control devices are provided, by which the elements of the tester can be automatically controlled, after input of a starting signal, for carrying out the individual steps of the method according to the invention.

16. Battery tester according to Claim 14 or 15, characterized in that the temperature-measuring devices have a temperature detector (14) with a measuring head (30) which can be placed against an outer surface of a battery wall and in which two temperature sensors (46, 48) are provided, in that one of these temperature sensors is attached to a relatively large, but light-weight metal plate, the front side of which lies opposite the battery wall at a small, predetermined distance, in that the other temperature sensor is arranged in such a way that it is flowed around by the ambient air and measures the room temperature and in that the battery temperature is established by means of comparison devices in dependence on the output signals of the two temperature sensors and in dependence on measurement curves stored in the memory devices.

17. Battery tester according to Claim 16, characterized in that at least one (46) of the temperature sensors comprises a thermistor.

18. Battery tester according to Claim 16 or 17, characterized in that the measuring head (30) has on the outer side of the metal plate (50) a spacer ring (44), with the aid of which a defined, closed-off volume of air can be predetermined in operation between the outer side of the metal plate and the outer surface of the battery wall lying opposite it for the measuring operation.

19. Battery tester according to one of Claims 16 to 18, characterized in that the metal plate (50) is produced from stainless steel.

20. Battery tester according to one of Claims 16 to 19, characterized in that the measuring head (30) is articulated in the region of the lower end of a support (34) in the form of a U-shaped piece, the free end of which, remote from the measuring head, is supported in operation on the upper side of the battery to be tested.

21. Battery tester according to Claim 20, characterized in that the support (34) has an increased weight adjacent to the measuring head.

22. Battery tester according to Claim 21, characterized in that the support is formed as a moulding of plastic with a weight arranged at the measuring head.

23. Battery tester according to Claims 16 and 17, characterized in that the resistor provided on the metal plate (50) is formed as a bead consisting of a material with a negative temperature coefficient and, in particular, is inserted directly into an opening of the metal plate.

24. Battery tester according to one of Claims 14 to 23, characterized in that the battery to be tested can be connected to the battery tester via a connection cable by a battery terminal (28), which has on one side of the clip jaw a first contact element, which is connected to a current conductor of the connection cable designed for a high discharge current, and which has on the opposite side of the clip jaw at least one further contact element, which is connected to two further conductors of the connection cable which are respectively connected to a supply voltage terminal and a battery-voltage measuring terminal of the battery tester.

**25.** Battery tester according to one of Claims 14 to 24, characterized in that discharge-current setting devices are provided, which comprise a resistance network which is made up of a plurality of fixed resistors selected in the manner of a resistance decade.

**26.** Battery tester according to Claim 25, characterized in that a ratio of 1:2 for in each case two neigh-bouring resistance values is envisaged for the graduation of the resistance values of the fixed resistors.

**27.** Battery tester according to Claim 25, characterized in that the normal graduation is envisaged for the graduation of the resistance values of the fixed resistors.

**28.** Battery tester according to one of Claims 14 to 24, characterized in that discharge-current setting devices are provided, which comprise a plurality of parallel branches with in each case a fixed resistor and a variable resistor.

## Revendications

**1.** Procédé pour déterminer l'état d'une batterie au plomb, notamment d'une batterie de démarrage, selon lequel on décharge la batterie par un courant de décharge pendant la durée d'un intervalle de temps limité et on mesure la tension de décharge à la fin de cet intervalle pour déterminer l'état de charge de la batterie, procédé comprenant les étapes suivantes :

a) au cours d'une première étape de décharge (phase 1) on décharge la batterie pendant la durée de quelques secondes pour compenser l'affaissement de tension avec un premier courant de décharge, d'intensité élevée,

b) au cours d'une seconde étape de décharge (phase 2) on décharge la batterie (38) pendant la durée de quelques minutes, avec un second courant de décharge ($I_{20}$) constant, d'intensité relativement faible, prédéterminée,

c) à la fin de la seconde étape de décharge on mesure la température et la tension de la batterie à l'aide d'installations de mesure de température et de tension (12, 14),

d) en fonction de la température et de la tension mesurées de la batterie, à l'aide de données enregistrées dans des moyens d'enregistrement, et correspondant à un premier faisceau de courbes d'états de charge, on détermine l'état de charge relatif de la batterie à contrôler par rapport à celui d'une batterie de ce type, complètement chargée,

e) au cours d'une troisième étape de décharge (phase 3) on décharge la batterie pendant la durée d'un intervalle de quelques secondes avec un troisième courant de décharge, constant, d'intensité élevée précise prédéterminée,

f) on mesure la tension de fin de décharge obtenue par cette troisième étape de décharge, à l'aide d'installations de mesure de tension (12),

g) à l'aide d'installations de comparaison (40) on détermine la différence de tension entre la valeur mesurée de la tension de fin de décharge et une valeur de tension qui, selon les données enregistrées dans les installations d'enregistrement pour un second faisceau de courbes d'états de charge pour une nouvelle batterie (38), partant de l'état de charge déterminé à la fin de la seconde étape de décharge (phase 2), pour la température déterminée à la fin de la seconde étape de décharge (phase 2) et pour une décharge avec le troisième courant de décharge, constant, d'intensité prédéterminée de manière précise, et

h) sur la base de la différence de tension obtenue, on détermine à l'aide des données enregistrées dans les installations d'enregistrement (10) d'une courbe associée à la perte de capacité de démarrage du type de batterie à contrôler, la perte relative de capacité de démarrage correspondant à l'état de charge par rapport à une batterie neuve (38), pour le même état de charge, ou encore on détermine la capacité de démarrage existant encore à l'instant du contrôle,

le premier et le second faisceau de courbes d'états de charge comprenant des courbes qui s'appliquent au type de batterie à contrôler ainsi que pour le second et le troisième courant de décharge et combinent la tension de la batterie et l'état de charge aux températures concernées.

2. Procédé selon la revendication 1, caractérisé en ce que pour le troisième courant de décharge, d'intensité prédéterminée, on choisit une fraction de l'intensité du courant de contrôle à froid, notamment la moitié de l'intensité de contrôle à froid.

3. Procédé selon la revendication 1, caractérisé en ce que pour le second courant de décharge, faible dans la seconde étape de décharge, on choisit un courant de décharge associé à la capacité nominale de la batterie, notamment le courant nominal pour une décharge pendant 20 heures.

4. Procédé selon l'une des revendications 1 à 3, caractérisé en ce que pour la première étape de décharge on prédétermine un intervalle allant jusqu'à environ 10 secondes et de préférence de l'ordre de 2 à 5 secondes.

5. Procédé selon l'une des revendications 1 à 4, caractérisé en ce que pour la seconde étape de décharge, on prédétermine un intervalle allant jusqu'à 30 minutes, de préférence compris entre 3 et 10 minutes.

6. Procédé selon l'une des revendications 1 à 5, caractérisé en ce que pour la troisième étape de décharge, on prédétermine un intervalle allant jusqu'à environ 20 secondes, de préférence de l'ordre de 5 secondes.

7. Procédé selon l'une des revendications 1 à 6, caractérisé en ce que la mémoire morte contient les faisceaux des courbes d'états de charge et des courbes de perte de capacité de démarrage de plusieurs types de batteries et l'information concernant le type de batterie à contrôler est obtenue par l'introduction des valeurs de la capacité nominale et du courant de contrôle à froid du type de batterie à contrôler à l'aide d'un dispositif d'entrée dans une installation d'enregistrement coopérant avec la mémoire morte, cette introduction se faisant avant que l'on exécute les mesures.

8. Procédé selon l'une des revendications 1 à 7, caractérisée en ce que les différentes étapes de procédé sont effectuées automatiquement le cas échéant après l'introduction des informations concernant le type de batterie à contrôler, en fonction d'un signal de démarrage par des installations de commande.

9. Procédé selon l'une des revendications 1 à 8, caractérisé en ce que la mesure de température est effectuée à l'aide d'installations de mesure de température de façon à déterminer la température de la batterie en fonction d'une valeur de mesure influencée par la température ambiante pour la température et d'une valeur de mesure dépendant uniquement de la température ambiante.

10. Procédé selon la revendication 9, caractérisé en ce que l'on fait une approximation déterminant la température réelle de la batterie à l'aide de courbes de compensation de température enregistrées dans une installation d'enregistrement.

11. Procédé selon l'une des revendications 1 à 10, caractérisé en ce qu'on maintient constants les courants de décharge au moins pendant la seconde et la troisième étape de décharge à l'aide d'installations de décharge comprenant des résistances fixes dont les valeurs sont échelonnées de manière déterminée.

12. Procédé selon la revendication 11, caractérisé en ce que les tolérances des résistances fixes sont compensées à l'aide de tableaux de tarage enregistrés dans une mémoire.

13. Procédé selon l'une des revendications 1 à 12, caractérisé en ce que pendant la première étape de décharge on prend à la batterie une quantité de charge minimale, qui est sensiblement égale à la quantité de charge prise en 5 minutes par le courant de décharge correspondant à une période de 20 heures pour la décharge de la batterie.

14. Appareil de contrôle de batterie pour la mise en oeuvre du procédé selon l'une des revendications 1 à 13, comprenant les éléments suivants :
    - des installations de mesure de tension (12), des installations de mesure de température (14), des installations d'enregistrement à l'aide desquelles on enregistre les courbes d'états de charge dépendant de la température pour un courant de décharge relativement faible, prédéterminé, et pour un courant de décharge élevé, prédéterminé, ainsi que les données d'une courbe de perte de capacité de démarrage associée à la perte de capacité de démarrage pour au moins un type de batterie, des installations de comparaison (10) pour comparer une tension de batterie mesurée avec les données inscrites dans les installations d'enregistrement pour les courbes d'état de charge et pour déterminer la différence entre la valeur de la tension finale de décharge mesurée et une valeur de tension qui serait valable selon les données inscrites dans les installations d'enregistrement (46) d'un faisceau de courbes d'état de charge pour une batterie neuve (38), en partant de l'état de charge déterminé à la fin de la seconde étape de décharge (phase 2) pour la température déterminée à la fin de la seconde étape de décharge (phase 2) et pour une décharge sous un troisième courant de décharge constant d'intensité élevée prédéterminée de manière précise ainsi que des installations d'exploitation (10) pour exploiter la différence mesurée à l'aide de la courbe de perte de capacité de démarrage et des installations de décharge pour décharger la batterie (38) pendant des intervalles de temps prédéterminés et à des intensités de courant de décharge, constantes, prédéterminées et des installations d'émission (22) pour fournir des informations concernant l'état de charge et la perte de capacité de démarrage de la batterie contrôlée (38).

15. Appareil de contrôle de batterie selon la revendication 14, caractérisé par des installations de commande, qui commandent les éléments de l'appareil de contrôle après entrée d'un signal de démarrage, automatiquement pour exécuter les différentes étapes du procédé selon l'invention.

16. Appareil de contrôle de batterie selon la revendication 14 ou 15, caractérisé en ce que les installations de mesure de température comportent un capteur de température ayant une tête de mesure (30) qui peut s'appliquer contre la surface extérieure d'une paroi de la batterie, tête qui comprend deux capteurs de température (46, 48), l'un de ces capteurs de température étant monté sur une plaque métallique relativement grande mais légère dont la face avant est en regard et à une faible distance prédéterminée de la paroi de la batterie et l'autre capteur de température est monté pour être balayé par l'air ambiant et mesure la température ambiante et en ce que la température de la batterie s'obtient par des installations de comparaison en fonction des signaux de sortie des deux capteurs de température ainsi qu'en fonction des courbes de mesure enregistrées dans les installations d'enregistrement.

17. Appareil de contrôle de batterie selon la revendication 16, caractérisé en ce qu'au moins l'un des capteurs de température (46) comprend une résistance NTC.

18. Appareil de contrôle de batterie selon l'une des revendications 16 ou 17, caractérisé en ce que la tête de mesure (30) présente, sur la face extérieure de la plaque métallique (56), une bague d'écartement (44) à l'aide de laquelle, en fonctionnement, on prédétermine entre la face extérieure de la plaque métallique et la surface extérieure de la paroi de batterie qui se trouve en regard, un volume d'air fermé, déterminé pour l'opération de mesure.

19. Appareil de contrôle de batterie selon l'une des revendications 16 à 18, caractérisé en ce que la plaque métallique (50) est en acier inoxydable.

20. Appareil de contrôle de batterie selon l'une des revendications 16 à 19, caractérisé en ce que la tête de mesure (30) est articulée au niveau de l'extrémité inférieure d'un support (34) en forme d'étrier dont l'extrémité libre éloignée de la tête de mesure s'appuie en fonctionnement contre le côté supérieur de la batterie à contrôler.

21. Appareil de contrôle de batterie selon la revendication 20, caractérisé en ce que le support (34) présente un poids élevé au niveau de la tête de mesure.

22. Appareil de contrôle de batterie selon la revendication 21, caractérisé en ce que le support est une pièce moulée en matière plastique avec un poids prévu au niveau de la tête de mesure.

23. Appareil de contrôle de batterie selon les revendications 16 et 17, caractérisé en ce que la résistance prévue sur la plaque métallique (50) est une perle en un matériau à coefficient de température négatif, notamment placée directement dans une ouverture de la plaque métallique.

24. Appareil de contrôle de batterie selon l'une des revendications 14 à 23, caractérisé en ce que la batterie à contrôler peut être reliée à l'appareil de contrôle de batterie par l'intermédiaire d'un câble de raccordement muni d'une pince pour batterie (28), comportant sur un côté du mors de la pince, un premier élément de contact relié à un conducteur électrique du câble de raccordement conçu pour un courant de décharge élevé, et le côté opposé du mors comporte au moins un autre élément de contact relié à deux autres conducteurs du câble de raccordement, ces conducteurs étant reliés à une borne d'alimentation en tension ou à une borne de raccordement de mesure de tension de batterie pour l'appareil de contrôle de batterie.

25. Appareil de contrôle de batterie selon l'une des revendications 14 à 24, caractérisé par des installations de réglage du courant de décharge comprenant un réseau de résistances composées de plusieurs résistances fixes choisies à la manière d'une cascade de résistances.

26. Appareil de contrôle de batterie selon la revendication 25, caractérisé en ce que l'échelonnement des valeurs des résistances fixes correspond à un rapport de $\frac{1}{2}$ pour respectivement deux valeurs de résistance voisines.

27. Appareil de contrôle de batterie selon la revendication 25, caractérisé par un échelonnement normal pour l'échelonnement des valeurs des résistances fixes.

28. Appareil de contrôle de batterie selon l'une des revendications 14 à 24, caractérisé par des installations de réglage du courant de décharge comprenant plusieurs branches en parallèle ayant chaque fois une résistance fixe et une résistance variable.

FIG.1

Strom

0,5 I$_{-18}$

Phase 1

Phase 2

Phase 3

I$_{20}$

0 $\longrightarrow$ 5 sec

5 min

(min) Zeit

0 $\longrightarrow$ 5 sec

FIG.2

Batteriespannung [v]

0    20    40    60    80    100

Ladezustand [%]

FIG.3

Batteriespannung [v]

0    20    40    60    80    100

Ladezustand [%]

18

FIG. 4

FIG.5a)

b)

c)

EP 0 447 928 B1

FIG. 6